# EUROPEAN PATENT APPLICATION

(11) **EP 3 226 417 A1**
(43) Date of publication of application: **04.10.2017**
(21) Application number: 15863634.0
(22) Date of filing: 19.11.2015
(51) Int. Cl.: H03K 19/177, G06F 7/00

(54) **DYNAMIC CIRCUIT DEVICE**

(30) Priority: 26.11.2014 JP 2014239033
(71) Applicant: NEC Space Technologies, Ltd., Fuchu-shi Tokyo 183-8551 (JP)
(72) Inventor: HIHARA, Hiroki, Fuchu-shi Tokyo 183-8551 (JP); WAKABAYASHI, Kazutoshi, Tokyo 108-8001 (JP)
(74) Representative: Vossius & Partner Patentanwälte Rechtsanwälte mbB
(86) International application number: PCT/JP2015/005793
(87) International publication number: WO 2016/084355

(57) **Abstract**

The present invention provides a dynamic circuit device that can prevent hardware and software from becoming larger in size and that can have smaller outside dimensions, less weight, and lower power consumption. For this purpose, the dynamic circuit device is provided with an operation instructing unit for instructing an operation and a cluster-layer wiring layer formed by disposing a plurality of cluster layers that include one or more lookup tables in which preset function elements are disposed and by connecting adjacent cluster layers with each other using cluster-layer connecting lines, wherein the dynamic circuit device changes the circuit configuration dynamically by changing operational states of the functional elements according to the instruction from the operation instructing unit.

## Description

### [Technical Field]

The present invention relates to a dynamic circuit device capable of performing a variety of data processing by dynamically changing a circuit configuration.

### [Background Art]

An FPGA (Field Programmable Gate Array) is known as a programmable device in which a circuit configuration of a data processing apparatus can be changed. For example, in Patent Documents 1 to 5, as one of techniques for implementing portions having different logic circuits on an FPGA, it is described that an initial netlist characterizing such a logic circuit is divided into many pages, and one circuit of each page is implemented on the FPGA. This makes it possible to implement a circuit of a size much larger than the physical capacity of the FPGA.

### [Citation List]

### [Patent Literature]

[PTL 1] Japanese Laid-open Patent No. 2000-40745
[PTL 2] PCT International Publication No. WO2006/046711
[PTL 3] Japanese Laid-open Patent No. 2010-199731
[PTL 4] Japanese Laid-open Patent No. 2010-003058
[PTL 5] Japanese Laid-open Patent No. 2009-237874
[PTL 6] Japanese Laid-open Patent No. 2008-541216

### [Disclosure of the Invention]

### [Technical Problem]

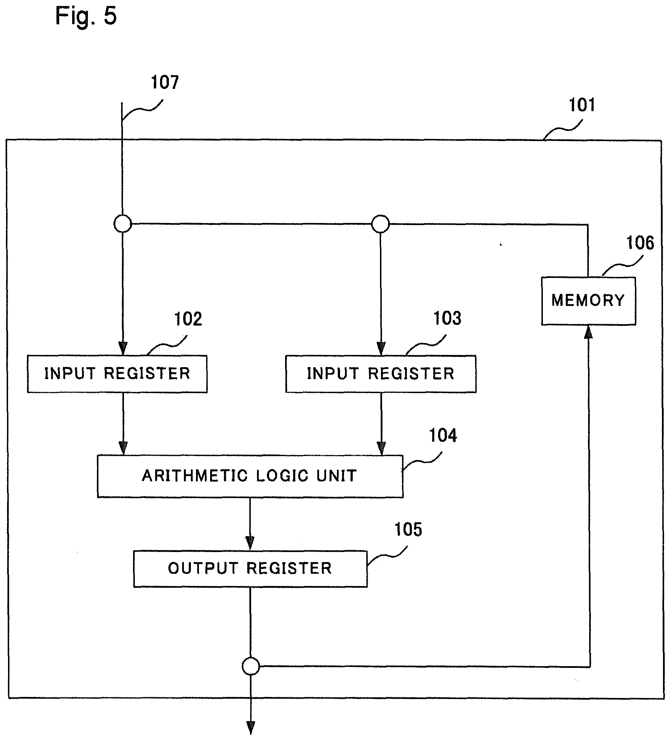

However, in the above-described data processing apparatus such as an FPGA or an SOG (System On Chip), a structure called a stored program method is adopted. Fig. 5 is a configuration diagram of a data processing apparatus of a stored program method.

A data processing apparatus 101 includes an input register 102, an input register 103, an arithmetic logic unit 104, an output register 105, and a memory 106.

The memory 106 stores information indicating a state of the data processing apparatus 101, and information on a route indicating a transfer source or transfer destination of data.

An arithmetic logic unit 104 sequentially reads out these pieces of information from a memory 106 and outputs calculated data and data to be calculated to a designated circuit (for example, another arithmetic logic unit). By this, data processing is performed.

A plurality of such arithmetic logic units 104 are prepared in advance, and by transferring calculated data and data to be calculated between these arithmetic logic units, the calculation result is outputted to the output register 105.

Specifically, calculation itself is realized by transmitting data between the arithmetic logic unit 104 and the memory 106, and information indicating a transmission source and a transmission destination is also sequentially written/read to the memory 106. For this reason, the scale of the peripheral circuit that transmits data and the size of the memory 106 that stores information are larger than that of the arithmetic logic unit 104 that performs calculation itself.

Therefore, the data processing apparatus 101 as a whole has a larger outside dimension, heavier weight, and higher power consumption than the arithmetic logic unit 104.

Since data processing that does not cause inconvenience even when parallel processing is performed in view of design is sequentially processed by a predetermined number of arithmetic logic units 104, software for replacing parallel processing with sequential processing is needed, and a data processing speed is sometimes slowed (data processing time is prolonged).

As one example of such software, there are a multi-process operating system, a multi-threaded operating system, and a multi-tasking operating system, and such software performs data transmission control according to a requested timing or order.

As described above, the data processing apparatus 101 is large in scale of hardware and software for performing data transmission control for requested data processing. This is an obstacle for downsizing of the outside dimension, weight reduction, and reduction in power consumption.

Therefore, a main object of the present invention is to provide a dynamic circuit device capable of suppressing the scale of hardware and software, and capable of downsizing, weight reduction, and low power consumption of the outside dimension.

### [Solution to Problem]

In order to solve the above-described problem, an invention relating to a dynamic circuit device that performs data processing by dynamically changing a circuit configuration is characterized by comprising an operation instructing unit for instructing an operation and a cluster-layer wiring layer in which a plurality of cluster layers including one or more lookup tables in which preset functional elements are disposed and cluster layers adjacent to each other are connected by a cluster-layer connecting line, wherein an operational state of a functional element changes in response to an instruction from the operation instructing unit (the operation instructing unit is also implemented on the cluster layer), thereby dynamically changing the circuit configuration.

### [Advantageous Effects of Invention]

According to the present invention, a state of a data processing apparatus, a transfer source and a transfer destination of data can be dynamically changed without using a stored program method, thereby dynamically changing a circuit configuration. By this, a memory for storing a program becomes unnecessary, the increase in the scale of hardware and software can be suppressed, and downsizing of the outside dimension, light weight, and low power consumption can be achieved.

### [Brief Description of Drawings]

[Fig. 1] Fig. 1 is a block diagram of a dynamic circuit device according to an example embodiment.
[Fig. 2A] Fig. 2A is a diagram illustrating a state machine as a functional element.
[Fig. 2B] Fig. 2B is a diagram illustrating a data path as a functional element.
[Fig. 2C] Fig. 2C is a diagram illustrating an arithmetic logic unit as a functional element.
[Fig. 2D] Fig. 2D is a diagram illustrating a crossbar switch as a functional element.
[Fig. 3] Fig. 3 is a block diagram of a dynamic circuit device for selectively packetizing image data from a first camera and image data from a second camera.
[Fig. 4A] Fig. 4A is a diagram illustrating an application example of a dynamic circuit device, and is a block diagram of a panchromatic image processing apparatus.
[Fig. 4B] Fig. 4B is a diagram illustrating an application example of a dynamic circuit device, and is a block diagram of a multispectral image processing apparatus.
[Fig. 4C] Fig. 4C is a diagram illustrating an application example of a dynamic circuit device, and is a block diagram of an infrared image processing apparatus.
[Fig. 4D] Fig. 4D is a diagram illustrating an application example of a dynamic circuit device, and is a block diagram of a radio wave image processing apparatus.
[Fig. 4E] Fig. 4E is a diagram illustrating an application example of a dynamic circuit device, and is a block diagram of an image recognition processing apparatus.
[Fig. 4F] Fig. 4F is a diagram illustrating an application example of a dynamic circuit device, and is a block diagram of a hyperspectral image processing apparatus.
[Fig. 5] Fig. 5 is a block diagram of a data processing apparatus applied to the description of the related art.

### [Description of Embodiments]

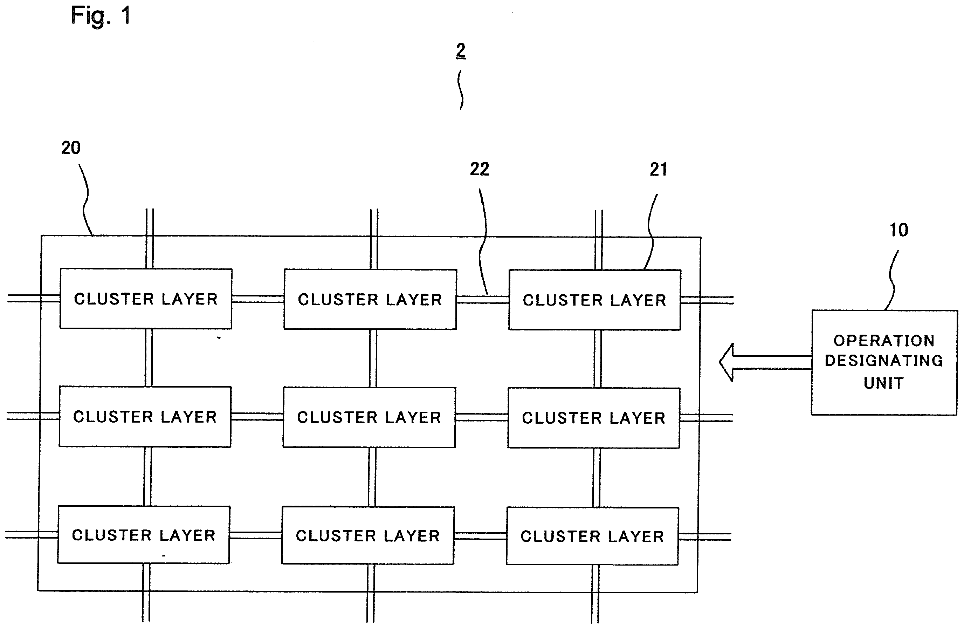

Embodiments of the present invention will be described. Fig. 1 is a block diagram of a dynamic circuit device 2 according to the present example embodiment. The dynamic circuit device 2 mainly includes an operation designating unit 10 and a cluster layer connecting layer 20. The operation designating unit 10 may also be implemented as a cluster layer.

The operation designating unit 10 has a table for designating an operation of the cluster layer connecting layer 20 or a function for changing a wiring inside a cluster layer.

The cluster layer connecting layer 20 is formed by physically connecting a plurality of cluster layers 21 with a cluster-layer connecting line 22. Although Fig. 1 illustrates a case in which all the cluster layers 21 are connected by the cluster-layer connecting line 22, there may be a case in which only specific cluster layers 21 are connected.

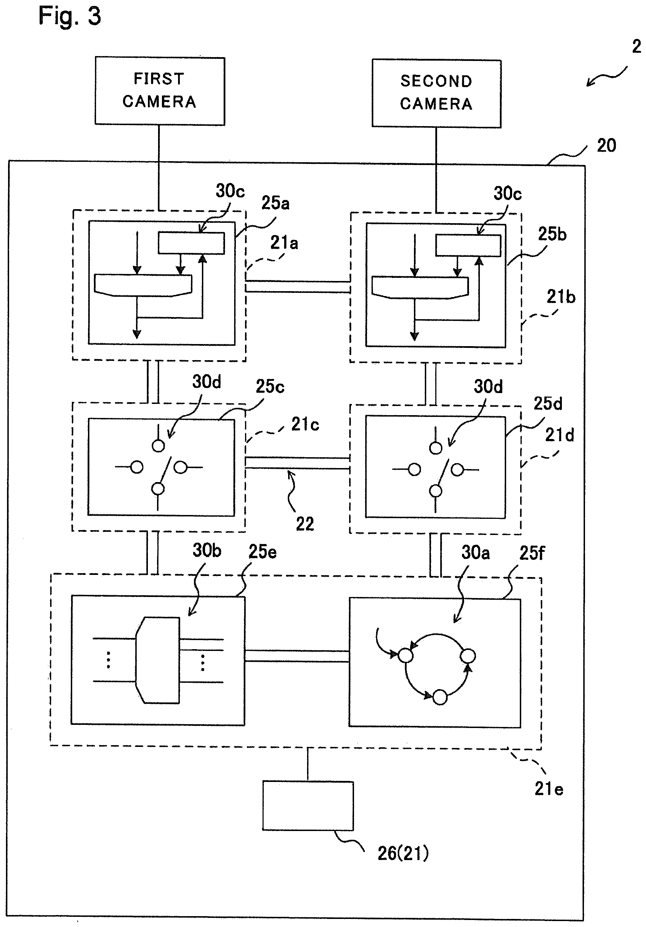

The cluster layer 21 includes a lookup table (LUT) layer 25 and a random circuit layer 26 (see, for example, Fig. 3). The random circuit layer 26 includes a functional element having an arbitrary fixed function assigned at the time of designing. Since the LUT layer 25 may be replaced with a function of changing a wiring inside the cluster layer 21 and a random circuit layer is also implemented as a cluster layer, the LUT layer 25 may be implemented by a function of changing a wiring inside the cluster layer 21.

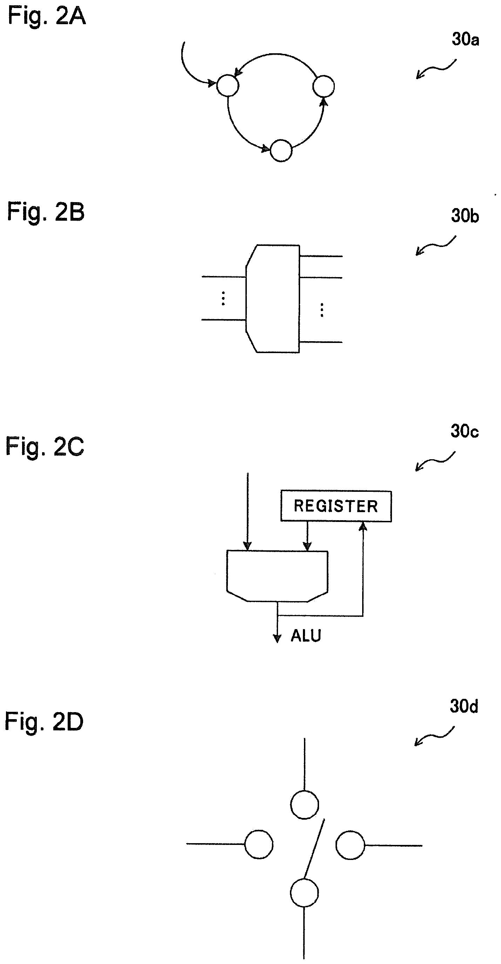

In the LUT layer 25, a functional element is disposed. Figs. 2A to 2D illustrate such a functional element. Fig. 2A is a diagram illustrating a state machine 30a, Fig. 2B shows a data path 30b, Fig. 2C shows an arithmetic unit (ALU: Arithmetic Logic Unit) 30c, and Fig. 2D shows functional elements of a crossbar switch 30d. The functional element disposed according to information stored in the LUT layer 25 is preset as a circuit design item. The functional element may be configured in such a way that a wiring inside the cluster layer 21 can be changed, or may be a random circuit.

The state machine 30a is a sequential circuit that instructs a next state depending on an input condition and a current state (depending on a progress state of data processing). Accordingly, a circuit state changes according to the contents of the state machine 30a (a data processing procedure changes).

The data path 30b is a transmission path for transmitting data, and stores information on a route indicating a transfer source or a transfer destination of data. The transfer source and transfer destination of data can be changed by an instruction of an operation designating unit. The arithmetic unit 30c is a predesigned arithmetic functional element, and is provided with a register and the like.

The crossbar switch 30d is a node for switching the data path 30b, and performs a switching operation according to an instruction from the state machine 30a. In other words, the circuit configuration changes according to an instruction from the state machine 30a.

An operation of the dynamic circuit device 2 having such a configuration will be described. Since an operation of the dynamic circuit device 2 varies dynamically, here, a configuration illustrated in Fig. 3 will be described as an example. Fig. 3 is a block diagram of the dynamic circuit device 2 for selectively packetizing image data from a first camera and image data from a second camera.

In Fig. 3, the cluster-layer connecting line 22 connects only cluster layers 21a to 21e, and is not connected to LUTs 25a to 25f in the cluster layers 21 a to 21e. Whether or not the cluster-layer connecting line 22 is connected to the LUTs 25a to 25f changes dynamically in an actual process, and therefore, a connection state between the cluster-layer connecting line 22 and the LUTLUTs 25a to 25f is not specified.

In the cluster layer connecting layer 20, five cluster layers 21a to 21e are disposed. The cluster layers 21a and 21b include LUTs 25a and 25b in which the arithmetic logic unit 30c is disposed as a functional element. The cluster layers 21c and 21d include LUTs 25c and 25d in which the crossbar switch 30d is disposed as a functional element. The cluster layer 21e includes an LUT 25e in which the arithmetic logic unit 30c is disposed as a functional element and an LUT 25f in which the state machine 30a is disposed.

Further, the cluster layer 21a and the cluster layer 21 c, the cluster layer 21 c and the cluster layer 21e, the cluster layer 21b and the cluster layer 21d, the cluster layer 21 c and the cluster layer 21d are each connected by the cluster-layer connecting line 22.

The first camera is connected to the cluster layer 21a, and the second camera is connected to the cluster layer 21b.

At this time, each of the computing units 30c disposed in the cluster layers 21a and 21b performs a process of converting analog image signals input from the first camera and the second camera into digital data.

The data path 30b and the state machine 30a disposed in the cluster layer 21 e add information such as a header to input data and perform packetization.

The cluster layers 21 c and 21 d switch circuit paths based on operation information from the operation designating unit 10. For example, when packetizing the image data from the first camera, the crossbar switch 30d of the cluster layer 21c switches in such a way that the cluster layer 21 a and the cluster layer 21e are connected to each other. The crossbar switch 30d of the cluster layer 21d switches in such a way that the cluster layer 21c and the cluster layer 21d are not connected.

As a result, the image data from the first camera is transmitted to the cluster layer 21 a, the cluster layer 21 c, and the cluster layer 21 e. The image data from the second camera is transmitted to the cluster layer 21b and the cluster layer 21 d, but is not transmitted to other places.

On the other hand, when packetizing the image data from the second camera, the crossbar switch 30d of the cluster layer 21c switches in such a way that the cluster layer 21d and the cluster layer 21e are connected. The crossbar switch 30d of the cluster layer 21d switches in such a way that the cluster layer 21 c and the cluster layer 21b are connected.

As a result, the image data from the second camera is transmitted to the cluster layer 21b, the cluster layer 21d, the cluster layer 21c, and the cluster layer 21 e. The image data from the first camera is not transmitted from the cluster layer 21a to the cluster layer 21b.

As described above, since the circuit configuration changes based on operation information from the operation designating unit 10, for example, analog data processing for signals from the second camera can be performed (parallel processing can be performed) while analog data processing on image data from the first camera is performed and packetized, and therefore, it is possible to speed up data processing.

As illustrated by the cluster layer 21 e, the number of functional elements that can be shared can be reduced, and therefore, it is possible to reduce the size, cost, and weight.

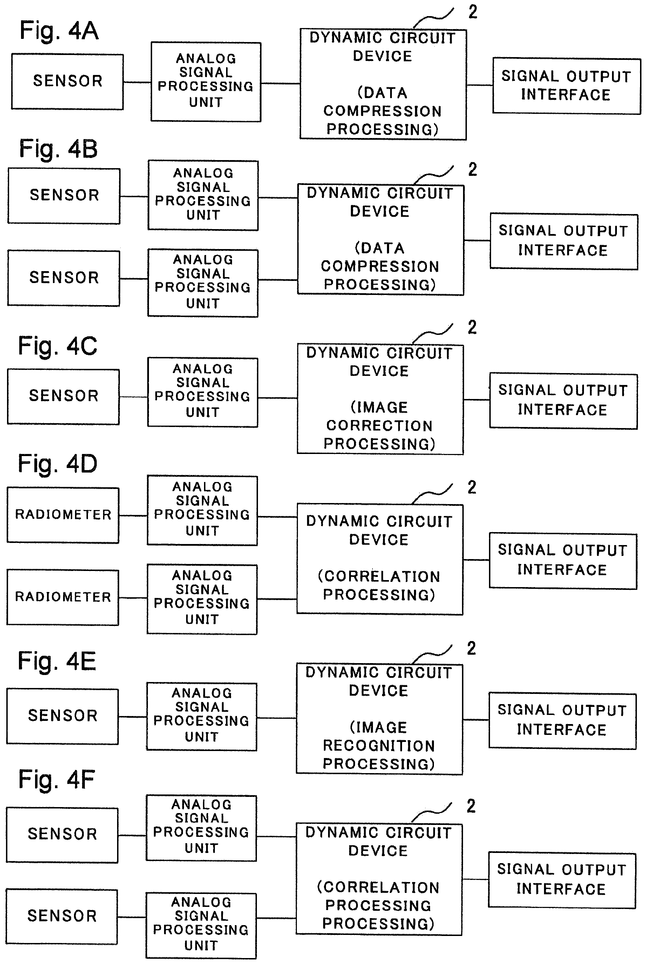

Such a dynamic circuit device 2 can be applied to an apparatus as illustrated in Figs. 4A to 4F. Fig. 4A illustrates a block diagram of a panchromatic image processing apparatus, Fig. 4B illustrates a block diagram of a multispectral image processing apparatus, Fig. 4C illustrates a block diagram of an infrared image processing apparatus, Fig. 4D illustrates a block diagram of a radio wave image processing apparatus, Fig. 4E illustrates a block diagram of an image recognition processing apparatus, and Fig. 4F illustrates a block diagram of a hyperspectral image processing apparatus.

These image processing apparatuses have substantially the same configuration, and analog signal processing such as brightness adjustment or noise removal is performed in an analog signal processing unit of a detection signal acquired by a sensor. Thereafter, an image signal is input to the dynamic circuit device 2, converted into a digital signal, and data processing is performed according to a set function. Each function set at this time is composed of the above-described cluster layer, LUT layer, and the like.

The sensor of the panchromatic image processing apparatus illustrated in Fig. 4A is a panchromatic sensor, and acquires an image with only one specific wavelength band. Therefore, an image to be acquired is a grayscale image from white to black.

With such a configuration, an analog signal processing unit performs analog signal processing such as brightness adjustment on a signal from a sensor. Thereafter, the dynamic circuit device 2 converts an analog signal processed signal into a digital signal and compresses the data. A data compression function is composed of the above-described cluster layer, LUT layer, and the like.

The multispectral image processing apparatus illustrated in Fig. 4B includes a plurality of sensors having different wavelength bands, and a photographing unit including an analog signal processing unit. Each sensor has the same configuration as the panchromatic sensor illustrated in Fig. 4A.

In the infrared image processing apparatus illustrated in Fig. 4C, the sensor is an infrared sensor and detection characteristics of each pixel need to be corrected. Therefore, an analog signal processing unit performs analog signal processing on data of an infrared image from a sensor (a camera). The dynamic circuit device 2 converts an analog signal processed signal into a digital signal string and performs processing for correcting offset values or white blemishes for each pixel.

In the radio wave image processing apparatus illustrated in Fig. 4D, the sensor is a radio wave sensor, from which a received radio wave signal is outputted. An analog processing unit performs analog signal processing on a signal from a sensor. The dynamic circuit device 2 converts an analog signal processed signal into a digital signal string and performs correlation processing.

The image recognizing processing apparatus illustrated in Fig. 4E inputs an image from a camera (a sensor) and performs analog signal processing in an analog signal processing unit. The dynamic circuit device 2 converts an analog signal processed signal into a digital signal string and also extracts a characteristic image from a signal of the digital signal string to calculate the area or a center value of the image. Image recognition (image extraction) is performed on image data subjected to analog signal processing using parameters such as the area and a center value of the image. Processing to insert parameters into the extracted image is then performed.

In the hyperspectral image processing apparatus illustrated in Fig. 4F, grayscale images of different wavelengths are inputted from a plurality of cameras (sensors) to respective analog signal processing units, and analog signal processing is performed. The dynamic circuit device 2 then edits a signal subjected to analog signal processing into a digital signal string and performs a process of applying correlation processing.

Although, in the above-described description, a memory (or a register) is not included in a functional element, it is possible to include the memory. In this case, the memory is disposed in an LUT, and whether or not to use this memory is determined by disposing a crossbar switch and controlling its operation. As a result, control information can be stored and data can be temporarily held, and a QoS (Quality of Service) function such as priority control can be implemented.

It is also possible to switch a failed cluster layer to a normal cluster layer by a crossbar switch, which leads to improvement in reliability.

As described above, a dynamic circuit device can reduce the outside dimension, weight, and power consumption for controlling transmission of data with respect to required operational functions.

Increase in the scale of hardware and software can be suppressed, and the outside dimension, weight, power consumption can be suppressed.

Although the present invention has been described with reference to the above-described example embodiments (and examples), the present invention is not limited to the above-described example embodiments (and examples). A variety of changes that can be understood by those skilled in the art within the scope of the present invention can be made to the configuration and details of the present invention.

This application is based upon and claims the benefit of priority from Japanese patent application No. 2014-239033, filed on November 26, 2014, the disclosure of which is incorporated herein in its entirety by reference

### [Reference signs List]

- 2: dynamic circuit device
- 10: operation designating unit
- 20: cluster layer connecting layer
- 21: cluster layer
- 22: cluster-layer connecting line
- 25: lookup table (LUT) layer
- 26: random circuit layer
- 30a: state machine (functional element)
- 30b: data path (functional element)
- 30c: arithmetic logic unit (functional element)
- 30d: crossbar switch (functional element)

## Claims

1. A dynamic circuit device that performs a desired data processing by dynamically changing a circuit configuration comprising:
operation instructing means for instructing an operation; and
a cluster-layer wiring layer in which a plurality of cluster layers including one or more lookup tables in which preset functional elements are disposed and cluster layers adjacent to each other are connected by a cluster-layer connecting line, wherein
an operational state of the functional element changes in response to an instruction from the operation instructing means, thereby dynamically changing the circuit configuration.

2. The dynamic circuit device according to Claim 1, wherein
the functional element comprises at least one of a crossbar switch, a memory, an operation element, a state machine, and a data path.

3. The dynamic circuit device according to Claim 1 or 2, wherein
the cluster-layer wiring layer performs at least data compression processing for compressing input data, image correction processing for performing correction processing of input image data, correlation processing for performing correlation processing between input data, and image recognizing processing for image recognition based on input data.
